# EUROPEAN PATENT SPECIFICATION

(11) **EP 2 905 354 B1**
(45) Date of publication and mention of the grant of the patent: **15.09.2021**
(21) Application number: 15154232.1
(22) Date of filing: 06.02.2015
(51) Int. Cl.: C23C 14/50, C23C 14/54, H01J 37/32, H01J 37/34

(54) **Method of processing a substrate**
Verfahren zur Verarbeitung eines Substrats
Procédé de traitement d'un substrat

(30) Priority: 07.02.2014 GB 201402126
(43) Date of publication of application: 12.08.2015
(73) Proprietor: SPTS Technologies Limited, Newport Gwent NP18 2TA (GB)
(72) Inventor: Wilby, Anthony Paul, Bristol, BS37 7YJ (GB); Burgess, Stephen R, Gwent, NP23 5NA (GB)
(74) Representative: Wynne-Jones IP Limited

(56) References cited:
- EP-A1- 2 530 183
- US-A- 4 565 601
- US-A1- 2003 168 174
- US-A1- 2009 310 648
- GOODMAN DANIEL: "Effect of wafer bow on electrostatic chucking and back side gas cooling", JOURNAL OF APPLIED PHYSICS, AMERICAN INSTITUTE OF PHYSICS, US, vol. 104, no. 12, 16 December 2008 (2008-12-16), pages 124902-124902, XP012116889, ISSN: 0021-8979, DOI: 10.1063/1.3043843
- "ELECTROSTATIC WAFER HOLDER FOR WAFER COOLING DURING REACTIVE ION ETCHING", IBM TECHNICAL DISCLOSURE BULLETIN, INTERNATIONAL BUSINESS MACHINES CORP. (THORNWOOD), US, vol. 31, no. 1, 1 June 1988 (1988-06-01), pages 462-464, XP000119644, ISSN: 0018-8689

## Description

This invention relates to a method of processing a substrate by physical vapour deposition (PVD). PVD, as described in US 2003/168174 A1, is widely used in the semiconductor industry and related industries for example to deposit high purity thin films by sputter deposition. It is usually desirable to maximise the deposition rate of the sputtered film in order to meeting the requirements of high volume manufacturing. However, there are significant problems in integrating high deposition rate PVD processes with the manufacturing environment. The deposition rate may be increased by increasing the power supply to the sputter target. However, as this power increases, the semiconductor wafer (or other substrate) tends to heat up. This heating of the wafer is due to a number of factors such as condensation of the sputtered flux, the kinetic energy of the sputtered flux and reflected neutral species, radiative heating, and charged particle bombardment.

For many applications, it is necessary to maintain the wafer at as low a temperature as possible to avoid deleteriously affecting materials that have previously been deposited. Additionally, adhesives may be present which may be damaged by elevated temperatures. Also, excessive heating may affect the properties of deposited material in undesirable ways, such as by increasing the stress of the deposited layer or increasing its grain size.

In a typical sputtering system, the substrate to be processed is positioned on a platen. Heat can be transferred from the substrate to the platen (and vice versa) by conduction, convection and radiation. At typical sputtering pressures, convective heat transfer is low, and for temperatures below around 300°C radiative transfer is expected to be a secondary consideration. For this reason, conductive heat transfer is typically used to manage the temperature of the substrate. Two approaches are commonly used in the art to improve the cooling of the wafer. The first process is to hold the wafer to the surface of the platen by means of a mechanical or electrostatic clamp and then passing gas into the cavity behind the wafer and the platen top. Electrostatic chucks use the principle of electrostatic attraction to impart a clamping force on the substrate while the mechanical clamp is typically an annular fixture which retains the edge of the wafer. This can increase heat transfer due to the enhanced conduction associated with the contact between the substrate and the electrostatic chuck. In addition, a gas back pressure may be applied to the underside of the substrate in order to further improve heat transfer by convection. Significant problems are encountered when it is necessary to clamp highly warped, damaged, taped, or insulated wafers. In addition, the use of the electrostatic chucks may not be compatible with high power sputter processes, due to the temperature limitations of the materials used in its construction. Also, particulate materials may be added to the underside of the wafer which experiences the clamping force. Further still, mechanical damage may be caused to the underside of the wafer. The second known cooling process is a back-fill process, in which film deposition is temporarily stopped before the back-fill process is performed. During this time, the process module is isolated from the vacuum pumping system, and the module is filled with an inert gas at a pressure high enough for heat transfer to occur readily. Typically, a back-fill process may last for sixty seconds at a pressure of one Torr. Additional time is then required to depressurise the module and to achieve the required vacuum conditions so that the sputtering process may be continued. The deposition of a thick film may require several back-fills during the process to keep the wafer at a sufficiently low temperature. This causes a significant drop in throughput, which reduces productivity and therefore is highly commercially undesirable.

The present invention, in at least in some of its embodiments, addresses the above described problems.

For the avoidance of doubt, the term 'gas' as used herein is understood to refer to mixtures of gases as well as to pure gases of a single chemical composition.

According to a first aspect of the invention there is a provided a method of processing a substrate by physical vapour deposition (PVD) in which the substrate is supplied with a cooling gas for cooling the planar substrate so that, during the PVD process, the substrate is lifted from a substrate support and is cooled.

It is believed that the present invention provides a new paradigm for cooling a substrate during PVD. Prior art approaches typically involve the use of a clamping arrangement to clamp the substrate to the substrate support during PVD. The present invention overturns the received wisdom in the field.

Using the present invention, it is possible to provide improved cooling by way of enhanced convection between the substrate and the substrate support. Additionally, the present invention may protect a surface of the substrate which is not processed by the PVD from particulate materials and/or damage associated with mechanical contact caused by clamping. Surprisingly, it has been found that the substrate can be lifted by the cooling gas without unduly affecting the PVD process.

Typically, the substrate has an upper surface which is subjected to the PVD process. The substrate may have a lower surface. The cooling gas may be supplied to the lower surface at a pressure sufficient to lift the substrate from the substrate support.

Typically, the substrate is wholly lifted from the substrate support. In these embodiments, the substrate can be regarded as floating above the substrate support. Typically, the substrate is not lifted from the substrate support by a great amount. The vertical displacement between the substrate and the substrate support during lifting may be 3mm or less, preferably 1mm or less.

The PVD process may be performed for a period of time. Typically, the substrate is lifted from the substrate support for at least 50% of said period of time, preferably for at least 75% of said period of time and more preferably for at least 90% of said period of time.

The PVD process may use a processing gas. The cooling gas may be of the same chemical composition as the processing gas. If the processing gas is a pure gas of a single chemical composition, then the cooling gas may be of the same chemical composition. If the processing gas is a mixture of gases, then the cooling gas may be of the same chemical composition. Alternatively, the cooling gas may utilise the same constituent gases as the processing gas but in different proportions. Alternatively still, the cooling gas may include one or more but not all of the constituent gases in the processing gas. These embodiments may assist in reducing any disruption or interference to the PVD process by the cooling gas. It will be appreciated that although the cooling gas may be the same composition as the processing gas, different pressures and flow rates may be utilised.

The cooling gas may be an inert gas. The cooling gas may be a noble gas, such as argon.

The PVD process may be performed at gas pressure in the range 0.1 to 20 mTorr.

The cooling gas may be supplied to the substrate at a flow rate in the range 0.5 to 5 sccm.

The PVD process may deposit a film on the substrate. The film may have an associated resistivity. The cooling gas may be supplied to the substrate at a flow rate which does not alter the resistivity of the film by more than ±5% in comparison to the average resistivity of films deposited with no cooling gas but otherwise under identical conditions. The average resistivity may be calculated as the mean resistivity.

The substrate support may include a retaining portion for retaining the substrate. The retaining portion may be configured so that, when the substrate is disposed on the substrate support, the retaining portion surrounds the substrate and is spaced therefrom. Surprising, it has been found that the use of a retaining portion of this type can cause the lifted wafer to maintain a stable, centred position. Without wishing to be bound by any particular theory or conjecture, it is believed possible that this effect is due to the cooling gas flow being channelled to maintain concentricity of the substrate within the retaining portion, with gas pressures being equalised around the boundary of the retaining portion. The surprising effect is that the substrate can be correctly positioned during PVD processing despite there being no mechanical constraint on the substrate. The retaining portion may protect the edge of the wafer from particulate material.

Typically, the retaining portion defines a recess for receiving the substrate which is only slightly larger than the substrate. The characteristic dimensions of the recess may exceed the characteristic dimensions of the substrate by less than 5%, preferably less than 3%, most preferably less than 1%.

The substrate support may include a recess in which the substrate may be disposed. In these embodiments, the retaining portion may be a wall of the recess. Alternatively, the retaining portion may be a structure which is upstanding from a substrate receiving surface of the substrate support.

The retaining portion may define a substrate receiving area which is of the same general cross-sectional shape as the substrate to be received.

The retaining portion may annular.

The substrate support may include an internal structure having one or more apertures which allow the cooling gas to be supplied to the substrate. A plurality of apertures arranged in a suitable pattern may be used.

The substrate support may comprise an upper surface on which the substrate can be disposed, wherein the upper surface is non-planar. Other optional features of the upper surface are described in relation to the second aspect.

The PVD process may be a sputtering process. The sputtering process may be any convenient sputtering process, such as metal sputtering. Other PVD processes might be used. In addition to metal coatings, inorganic coatings such as ceramic coatings and organic coatings may be deposited onto the substrate by the PVD process.

The substrate may be processed by depositing a thin film thereon.

The substrate may be a semiconductor substrate.

The substrate may be a planar substrate such as a wafer.

The substrate may be of any conventional size and shape, such as a 300mm diameter silicon wafer.

According to a second aspect (not part of the invention) there is provided apparatus for processing a substrate by physical vapour deposition (PVD) including a substrate support and a cooling gas supply for supplying a cooling gas to the substrate so that, during the PVD process, the substrate is lifted from the substrate support, in which the substrate support is configured to allow lifting of the substrate during the PVD process.

The substrate support may be configured to receive the substrate so that an upper surface of the substrate is subjected to the PVD process and a lower surface of the substrate is supplied with cooling gas from the cooling gas supply.

The substrate support may include a retaining portion which is configured so that, when the substrate is disposed on the substrate support, the retaining portion surrounds a substrate spaced therefrom. The retaining portion may be as described in connection with the first aspect of the invention.

The substrate support may comprise an upper surface on which the substrate can be disposed. The upper surface may be non-planar.

The upper surface may have a non-planar profile which varies the function of radial position across the substrate support.

The upper surface may have a non-planar profile which, in use, enables the substrate i) to be supported by a peripheral region of the upper surface and ii) to be spaced apart from a central region of the upper surface.

The upper surface may be concave. The depth of the concavity may be in the range 0.5 to 0.2mm.

The substrate support may be a platen.

The apparatus may be a sputtering apparatus.

Typically, the apparatus includes a chamber in which the substrate support is positioned and a processing gas supply. The apparatus may include other features associated with a PVD process, such as a sputtering source. Such features may be conventional in nature, and as such will be well known to the skilled reader. Therefore, it is not considered necessary to describe these features in further detail.

An apparatus may be provided in combination with a substrate to be processed which is suitable to be lifted from the substrate support during PVD processing by the cooling gas.

Whilst the invention has been described above, it extends to any inventive combination of the features described above, or in the following description, claims and drawings. For example, any feature described in relation in the first aspect of the invention, also forms part of the second aspect and *vice versa.*

Embodiments of methods and apparatus in accordance with the invention will now be described with reference to the accompanying drawings, in which: -
Figure 1 is a semi-schematic diagram of an apparatus;
Figure 2 shows SEM images of AlCu films obtained using PVD sputtering (a) with a cooling gas of the invention (b) without a cooling gas of the invention;

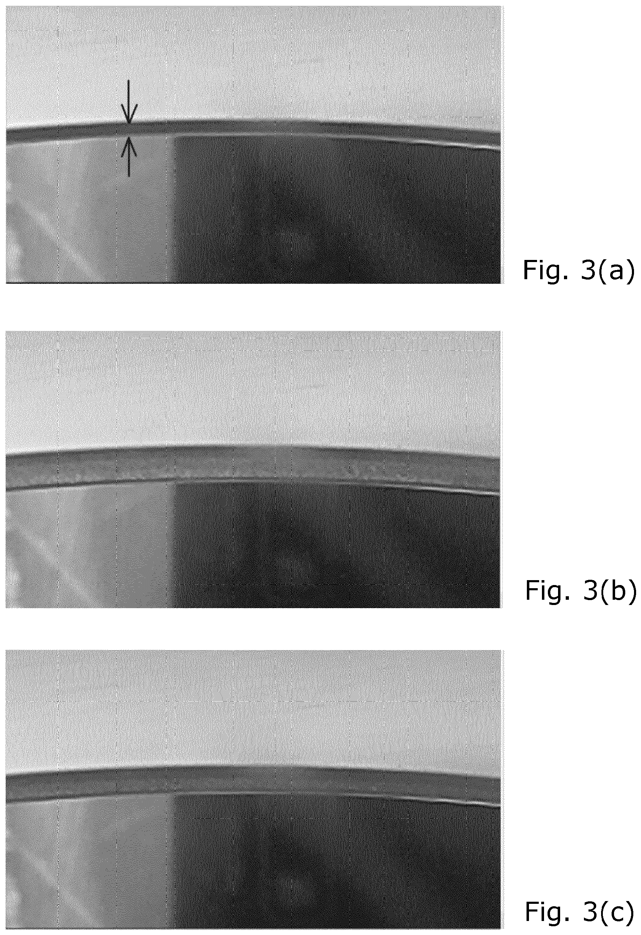

Figure 3 shows the position of a wafer with respect to a retaining ring (a) at an initial stage (b) shortly after cooling gas is introduced and (c) at an equilibrium configuration after cooling gas is introduced; Figure 4 shows the positional accuracy of a wafer achieved (a) with the retaining ring and (b) both with and without the retaining ring;
Figure 5 shows a dished platen;
Figure 6 shows wafer movement from a central position as a function of cooling gas flow rate; and
Figure 7 shows grain size at the centre and the edge of wafers processed using a number of platen configurations.

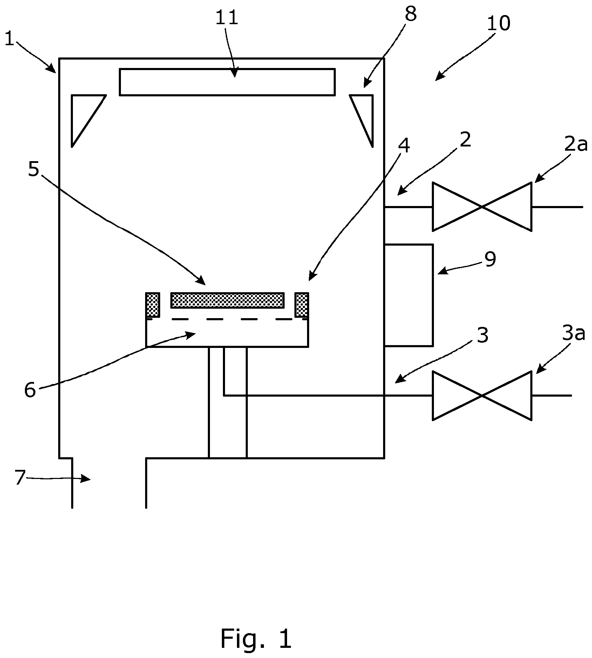

Figure 1 shows a PVD apparatus, depicted generally at 10. The PVD apparatus 10 is a sputter deposition system comprising a vacuum chamber 1 having a pumping port 7 which is connected to a suitable vacuum pumping arrangement (not shown). Inside of the chamber 1 is disposed a target 11 formed from the sputter material and an anode 8. Also located within the chamber 1 is a substrate support 6 in the form of a platen. The platen 6 has a retaining ring 4 upstanding from a substrate receiving surface of the platen 6. A substrate 5, typically a wafer, to be processed is located in the recess defined by the retaining ring 4 and the substrate receiving surface of the platen 6. The retaining ring 4 is sized so that the recess is slightly larger than the substrate 5. For example, a retaining ring having an inner diameter of 302mm is suitable for use in conjunction with a 300mm diameter wafer. A gas line 2 having an associated valve 2a is provided which allows a PVD process gas to be introduced into the chamber 1. A further gas line 3 having an associated valve 3a is provided. The further gas line 3 permits a 'backside' gas to be introduced to an underside of the substrate 5.

Sputtering is performed by creating a low pressure plasma in the chamber 1, typically in the presence of an inert gas but possibly in the presence of a reactive gas as well as, or in place of, the inert gas. The plasma is maintained by applying a potential between the target 11 and the anode 8. Positive ions are attracted to the target 11, and as a consequence of this ion bombardment some of the target material is removed from the target 11 and is transported to the substrate 5 being processed. Gas is removed from the vacuum chamber 1 through the pump port 7. Before and after the sputtering process, the wafer is transported into and out of the chamber 1 through a slot valve 9.

In one embodiment, the gas line 2 is used to introduce argon to the vacuum chamber 1 at a flow rate sufficient to provide a desired pressure in the chamber 1 so that sputtering can occur. The gas line 3 is used to introduce argon to the underside of the substrate 5. The platen 6 has an arrangement of apertures formed therein which enables the gas supplied by the gas line 3 to reach the underside of the substrate 5. Argon is introduced through gas line 3 at a flow rate sufficient to cause an increase in gas pressure on the underside of the substrate 5 so that improved heat transfer between the substrate 5 and the platen 6 can occur. Non-limiting examples of gas flow rates are a flow rate of around 100sccm for gas line 2 and a flow rate in the range 0.5-3sccm for gas line 3.

Table 1 shows the effect of varying the backside argon flow from 0 to 3sccm for an otherwise standard high pressure Al 0.5% Cu deposition process which ran for 150 seconds at 40kW plasma power with a process gas flow of 100sccm argon in gas line 2. A 300mm diameter silicon wafer was processed, and the resistivity of the sputtered Al Cu film was measured. Surprisingly, there was little difference in resistivity values (average or 1σ uniformity) over the range of backside gas flow studied.

**Table 1. Backside Ar flow (sccm) and measured sheet resistivity and resistivity uniformity.**

| Backside gas flow (sccm) | Sheet resistivity (mOhms/sq) | Uniformity 1σ% |
|---|---|---|
| 0 | 9.3744 | 1.418 |
| 0.5 | 9.3929 | 1.441 |
| 1 | 9.3891 | 1.836 |
| 2 | 9.3648 | 1.5 |
| 3 | 9.3419 | 1.37 |

Further experiments were performed to investigate the temperature of 300mm silicon wafers processed using a 40kW AlCu sputter process for 10 seconds on a platen controlled at 20°C. Experiments were performed with and without the gap backside gas flow provided by gas line 3. No preheat was used, and so the test was started with the substrate at ambient temperature. Non-reversible temperature stickers were used to assess the peak temperatures attained. With no backside gas flow, a peak temperature of 71°C was recorded, whereas with a backside gas flow of 1sccm, a lower peak temperature of 65°C was recorded. This demonstrates that the backside gas flow has a cooling effect.

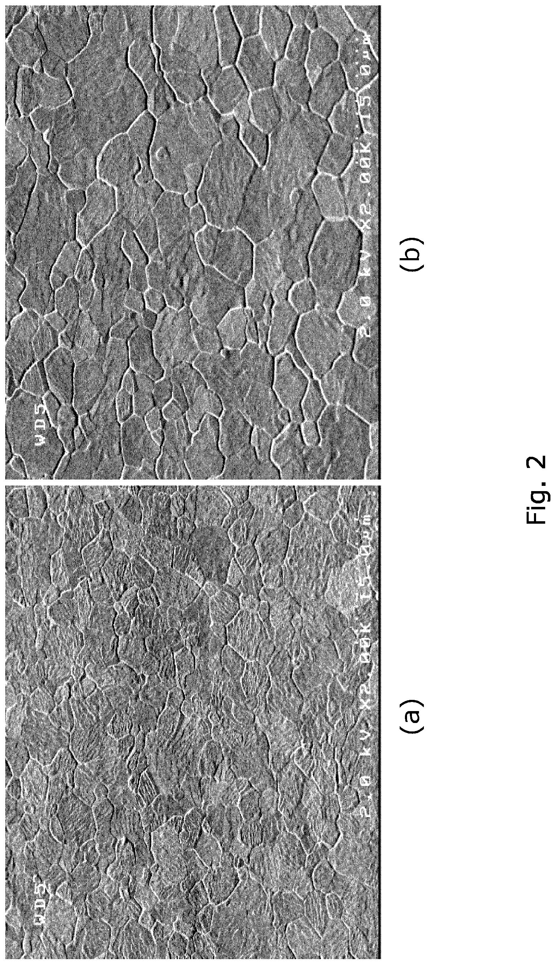

Measurements of grain size were also made. In these experiments, a 300mm silicon wafer was processed using a 40kW AlCu sputtering process for 150 seconds with and without a backside gas flow onto the underside of the wafer using a platen controlled to maintain a temperature of 60°C. A separate preheat was used to degas the silicon wafer to 300°C before the start of the deposition process. The AlCu grain size was then determined from SEM images of the surface of the film using the intercept method. It is known that in a sputtered metal film, the grain size increases at high temperature due to increased surface energy and mobility in the growing film. Figure 2 shows (a) an SEM image obtained using backside gas flow (BSG) and (b) an SEM image obtained without backside gas flow (no-BSG) onto the wafer. It can be clearly seen that the average grain size is lower when the backside gas flow is utilised. The average grain size shown in Figure 2(a) is 4.1 microns, whereas the average grain size in Figure 2(b) is 6.4 microns. From this, it follows that the temperature of the growing film is reduced by the use of the cooling backside gas.

In addition to the cooling associated with improved heat transfer, the backside gas provided by the present invention also generates a lift force on the substrate. The lift force can be sufficient to completely lift the substrate from the substrate holder so that the substrate is floating above the substrate holder during the PVD process. An advantage of this approach is that it reduces mechanical contact between the substrate and the substrate support. This is particularly advantageous in applications where it is desirable to minimise any contact to the underside of the substrate. Also, it is effective in reducing the level of particulate material on the underside of the substrate in comparison to standard handling systems. Table 2 shows the results of investigations into the presence of particulate material on the underside of substrates undergoing a 150 second process mimic with and without the presence of backside gas to lift the substrate from the substrate support. It can be seen that the use of the backside gas (at a flow rate of 1sccm) produces significant reductions in the level of particulate materials on the underside of the substrate. The backside gas approach is particularly effective at reducing particles in the larger bin sizes, with a 64% reduction being seen in particles greater than 2.0 microns in size. However, significant reductions are observed at all measured particle bin sizes.

**Table 2. Backside Particle Test of 150 second process mimic (BSG = backside gas)**

| Particle Bin Size | No BSG | 1sccm BSG | % change |
|---|---|---|---|
| 0.3 - 0.5um | 1702 | 1326 | -22% |
| 0.5 - 1.0um | 993 | 667 | -33% |
| 1.0 - 2.0um | 166 | 109 | -34% |
| AC (>2.0um) | 705 | 253 | -64% |
| SUM | 3566 | 2355 | -34% |

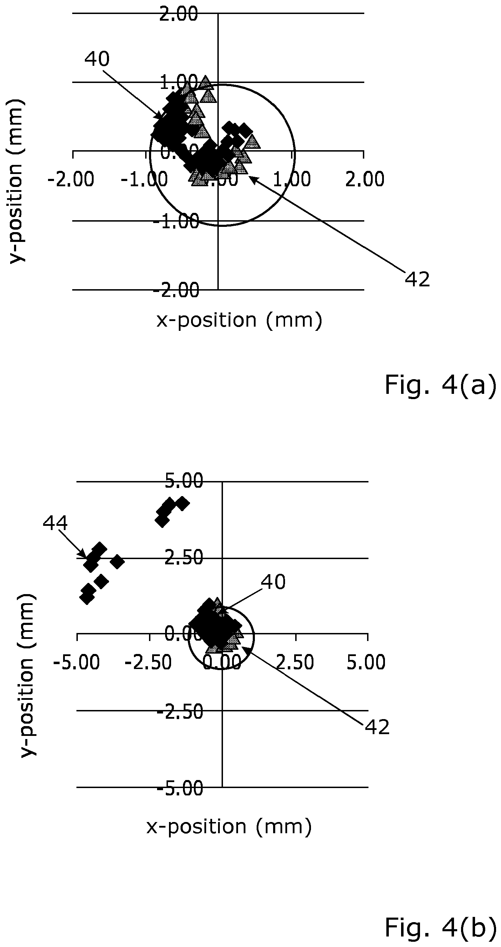

In the embodiment shown in Figure 1, the platen 6 has an upstanding retaining ring 4. The use of the retaining ring 4 provides additional benefits. In particular, the substrate appears to be correctly positioned during the PVD process despite there being no actual mechanical constraint on its position. It has been found that even when the substrate is floating due to the backside gas, the substrate remains centrally placed with respect to the substrate support. A consequence of this is that the substrate does not contact the retaining ring 4. This means that the present invention is particularly suitable where edge contact of the wafer must be avoided. However, it is believed that this feature is generally advantageous. Without wishing to be bound by any particular theory or conjecture, it is believed that the retaining ring acts to channel the backside gas flow to maintain the concentric position of the wafer within the recess defined by the platen 6, because gas pressure is equalised around the boundary of the retaining ring 4. Figure 4 shows the position of a wafer during processing with and without the retaining ring. With the retaining ring in place, repeatability runs were performed using backside gas flow at a flow rate of 1sccm and also without backside gas flow. Repeatability runs were performed also using backside gas flow at a flow rate of 1sccm with no retaining ring in place. Wafer position data were obtained post process using an optical aligner. Figure 4(a) shows movement data obtained with the retaining ring positioned on the platen, and Figure 4(b) shows the data of Figure 4(a) together with movement data obtained with no retaining ring in place. It can be seen from Figure 4(a) that the movement data 40 obtained with a backside gas flow are comparable to the movement data 42 obtained with a standard process using no backside gas flow. In comparison, it can be seen from movement data 44 in Figure 4(b) that without the retaining ring present the use of a backside gas flow causes significant movement of the substrate, which is frequently greater than 4mm from concentricity. It is likely that this significant movement is due to the presence of minimal friction between the substrate and the platen.

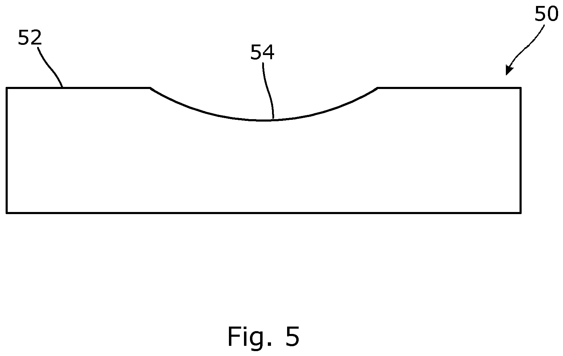

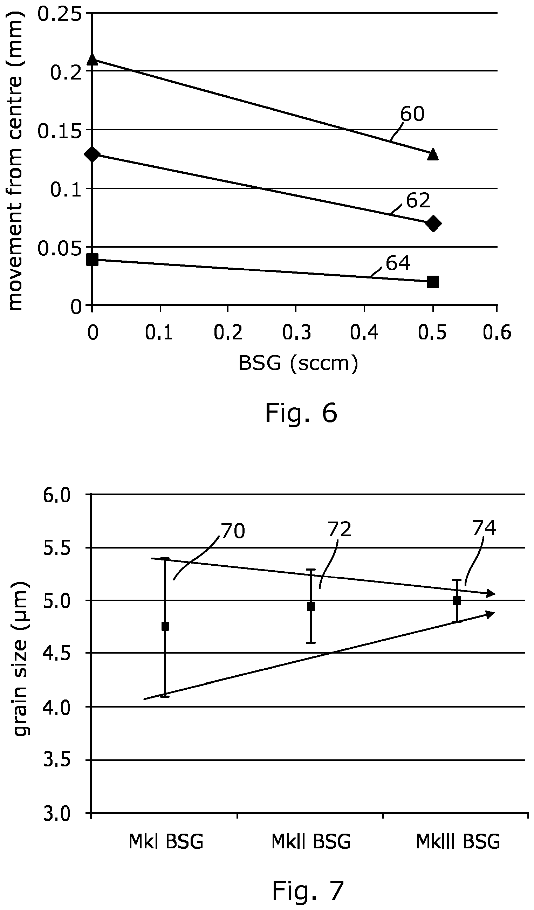

In further embodiments of the invention, the shape of the platen surface is refined in order to tailor the performance of the PVD apparatus. In this way, movement of the wafer from its initial position during processing can be reduced. It is also possible to reduce temperature variation across the wafer being processed. Figure 5 shows a platen 50 which has a shaped upper surface 52 on which the wafer is placed. It may be noted that the channels for allowing the background cooling gas to pass through the platen have been omitted from this figure for presentational simplicity. The upper surface 52 is dished so that some portions of the upper surface underlying the wafer are not in direct contact with the wafer. As shown in Figure 5, the upper surface 52 of the platen 50 is concave in the region 54. This provides a gap between the back of the wafer and the upper surface 52 of the platen 50 which varies with radial position. Without wishing to be limited by any particular theory or conjecture, it is thought that the provision of a dished platen reduces wafer movement by two mechanisms. Firstly, the increased volume at the back of the wafer means that less lift force is generated for a given gas flow. Secondly, if the backside gas flow is increased to the point where the wafer does not move, the wafer will move to the centre of the chamber to minimise the total potential energy of the system. Once the wafer is centralised within the dished portion it is in a stable equilibrium state, and little or no further movement will occur. Figure 6 shows movement of wafers from a central position as a function of the flow rate of the backside gas using a platen having a concave upper surface where the maximum depth of the concavity is 1.0mm. A 10 wafer handling test was performed, and Figure 6 shows maximum 60, average 62 and minimum 64 observed movement from centre. In further experiments, it has been established that significantly less movement from the central position is observed using the platen with the 1.0mm deep concavity in comparison to identical experiments performed with a platen having a planar upper surface and a platen having a 0.6mm deep concavity in its upper surface. However, the platen having the 0.6mm deep concavity provided superior positional results to the platen having a planar upper surface.

In some embodiments, it is possible for the temperature of the wafer to vary across the surface of the wafer. In particular, it has been observed that in some embodiments the temperature at the centre of the wafer is greater than the temperature at the periphery of the wafer. It has been found that platens having a concave upper surface can provide improved temperature uniformity as a function of radial position across the wafer. Figure 7 shows AlCu grain size obtained using an AlCu sputter process. Data were obtained using a platen having a planar upper surface, a platen having a 0.6mm deep concavity in the upper surface and a platen having a 1.0mm deep concavity in the upper surface. Figure 7 shows bars 70, 72, 74 corresponding to the planar, 0.6mm deep and 1.0mm deep platen upper surfaces, respectively. The uppermost part of each data bar shows the grain size at the centre of the wafer, and the lowermost parts of the each data bar shows the grain size at the edge of the wafer. It is recalled that the larger grain sizes correspond to higher temperatures. It can be seen that the variation in temperature from the centre to the edge of the wafer is reduced when concave platens are used. The smallest variation was achieved using the 1.0mm deep concave platen. It can be seen that the profile of the upper surface platen can be varied in order to tune the temperature gradient across the wafer. This is turn can be used to tune the properties of a deposited film. When the upper surface of the platen is concave, features such as the depth of the concavity and the diameter of the concave sectioned in relation to the dimensions of the wafer can be controlled in order to produce a desired effect. The invention also contemplates the use of other platen surface profiles in order to produce different temperature effects during processing of the wafer.

It will be apparent to the skilled reader that numerous variations and modifications on the principles described above might be contemplated. For example, other substrate support structures might be utilised. The substrate support may have a recess formed in a surface thereof which accommodates the substrate and acts to maintain the concentricity of the wafer. Other retaining structures might be contemplated, such as a split ring structure. Additionally, or alternatively, the directionality of the backside cooling gas might be controlled by controlling the way in which the cooling gas is introduced to the substrate. In the specific example provided above sputtering is performed. However, the principles of the invention may be readily extended to other PVD processes.

## Claims

1. A method of processing a planar substrate (5) by physical vapour deposition (PVD) in which the planar substrate (5) is supplied with a cooling gas for cooling the planar substrate (5) so that during the PVD process, the planar substrate is lifted from a substrate support (6) and is cooled.

2. A method of according to claim 1 in which the substrate (5) has an upper surface which is subjected to the PVD process and a lower surface, in which the cooling gas is supplied to the lower surface at a pressure sufficient to lift the substrate (5) from the substrate support (6).

3. A method according to claim 1 or claim 2 in which the substrate (5) is wholly lifted from the substrate support.

4. A method according to claim 3 in which the vertical displacement between the substrate (5) and the substrate support (6) during lifting is 3mm or less, preferably 1mm or less.

5. A method according to any one of claims 1 to 4 in which the PVD process is performed for a period of time, and substrate (5) is lifted from the substrate support (6) for at least 50% of said period of time.

6. A method according to any previous claim in which the PVD process uses a processing gas, and the cooling gas is of the same composition as the processing gas.

7. A method according to any previous claim in which the cooling gas is an inert gas.

8. A method according to any previous claim in which the substrate (5) is a wafer.

9. A method according to any previous claim in which the substrate (5) is a semiconductor substrate.

10. A method according to any previous claim in which the substrate support includes a retaining portion (4) which is configured so that, when the substrate is disposed on the substrate support (6), the retaining portion (4) surrounds the substrate (5) and is spaced therefrom.

## Patentansprüche

1. Verfahren zum Verarbeiten eines planaren Substrats (5) durch physikalische Gasphasenabscheidung (physical vapour deposition - PVD), wobei dem planaren Substrat (5) ein Kühlgas zum Kühlen des planaren Substrats (5) zugeführt wird, so dass während des PVD-Vorgangs das planare Substrat von einem Substratträger (6) angehoben und gekühlt wird.

2. Verfahren nach Anspruch 1, wobei das Substrat (5) eine obere Oberfläche, die dem PVD-Vorgang unterzogen wird, und eine untere Oberfläche aufweist, wobei das Kühlgas der unteren Oberfläche mit einem Druck zugeführt wird, der ausreicht, um das Substrat (5) von dem Substratträger (6) anzuheben.

3. Verfahren nach Anspruch 1 oder 2, wobei das Substrat (5) vollständig von dem Substratträger angehoben wird.

4. Verfahren nach Anspruch 3, wobei die vertikale Verschiebung zwischen dem Substrat (5) und dem Substratträger (6) während des Anhebens höchstens 3 mm, vorzugsweise höchstens 1 mm beträgt.

5. Verfahren nach einem der Ansprüche 1 bis 4, wobei der PVD-Vorgang für eine Zeitdauer durchgeführt wird und das Substrat (5) für wenigstens 50 % der Zeitdauer von dem Substratträger (6) angehoben wird.

6. Verfahren nach einem vorhergehenden Anspruch, wobei der PVD-Vorgang ein Verarbeitungsgas verwendet und das Kühlgas von derselben Zusammensetzung wie das Verarbeitungsgas ist.

7. Verfahren nach einem vorhergehenden Anspruch, wobei das Kühlgas ein Inertgas ist.

8. Verfahren nach einem vorhergehenden Anspruch, wobei das Substrat (5) ein Wafer ist.

9. Verfahren nach einem vorhergehenden Anspruch, wobei das Substrat (5) ein Halbleiterwafer ist.

10. Verfahren nach einem vorhergehenden Anspruch, wobei der Substratträger einen Halteabschnitt (4) beinhaltet, der konfiguriert ist, so dass, wenn das Substrat auf dem Substratträger (6) angeordnet ist, der Halteabschnitt (4) das Substrat (5) umgibt und davon beabstandet ist.

## Revendications

1. Procédé de traitement d'un substrat (5) plan par dépôt physique en phase vapeur (PVD) dans lequel le substrat (5) plan est alimenté en gaz de refroidissement destiné à refroidir le substrat (5) plan de sorte que, pendant le processus de PVD, le plan le substrat est soulevé d'un support de substrat (6) et est refroidi.

2. Procédé selon la revendication 1, dans lequel le substrat (5) possède une surface supérieure soumise au traitement PVD et une surface inférieure, dans laquelle l'alimentation de la surface inférieure en gaz de refroidissement se fait à une pression suffisante pour soulever le substrat (5) du support de substrat (6).

3. Procédé selon la revendication 1 ou la revendication 2, dans lequel le substrat (5) est entièrement soulevé du support de substrat.

4. Procédé selon la revendication 3, dans lequel le déplacement vertical entre le substrat (5) et le support de substrat (6) pendant le soulèvement est inférieur ou égal à 3 mm, de préférence inférieur ou égal à 1 mm.

5. Procédé selon l'une quelconque des revendications 1 à 4, dans lequel le procédé PVD est effectué pendant une certaine période de temps, et le substrat (5) est soulevé du support de substrat (6) pendant au moins 50 % de ladite période de temps.

6. Procédé selon l'une quelconque des revendications précédentes, dans lequel le procédé PVD utilise un gaz de traitement, et le gaz de refroidissement est de la même composition que le gaz de traitement.

7. Procédé selon l'une quelconque des revendications précédentes, dans lequel le gaz de refroidissement est un gaz inerte.

8. Procédé selon l'une quelconque des revendications précédentes, dans lequel le substrat (5) est une plaquette.

9. Procédé selon l'une quelconque des revendications précédentes, dans lequel le substrat (5) est un substrat semi-conducteur.

10. Procédé selon l'une quelconque des revendications précédentes, dans lequel le support de substrat comporte une partie de retenue (4) qui est conçue de sorte que, lorsque le substrat est disposé sur le support de substrat (6), la partie de retenue (4) entoure le substrat (5) et en est espacée.
